Europäisches Patentamt

European Patent Office

Office européen des brevets

(19)

(11) EP 0 786 092 B1

(12) **EUROPÄISCHE PATENTSCHRIFT**

(45) Veröffentlichungstag und Bekanntmachung des Hinweises auf die Patenterteilung:
**14.04.1999   Patentblatt 1999/15**

(21) Anmeldenummer: **95932633.1**

(22) Anmeldetag: **28.09.1995**

(51) Int Cl.$^6$: **G01R 15/24**

(86) Internationale Anmeldenummer:
**PCT/DE95/01348**

(87) Internationale Veröffentlichungsnummer:
**WO 96/12195 (25.04.1996 Gazette 1996/18)**

(54) **OPTISCHES MESSVERFAHREN UND OPTISCHE MESSVORRICHTUNG ZUM MESSEN EINER ELEKTRISCHEN WECHSELSPANNUNG ODER EINES ELEKTRISCHEN WECHSELFELDES MIT TEMPERATURKOMPENSATION**

OPTICAL MEASURING PROCESS AND DEVICE FOR MEASURING AN ELECTRIC A.C. VOLTAGE OR AN ELECTRIC ALTERNATING FIELD WITH TEMPERATURE COMPENSATION

PROCEDE ET DISPOSITIF DE MESURE OPTIQUES POUR MESURER UNE TENSION ALTERNATIVE ELECTRIQUE OU UN CHAMP ALTERNATIF ELECTRIQUE AVEC COMPENSATION THERMIQUE

(84) Benannte Vertragsstaaten:
**AT BE CH DE FR GB IT LI SE**

(30) Priorität: **12.10.1994   DE 4436455**

(43) Veröffentlichungstag der Anmeldung:
**30.07.1997   Patentblatt 1997/31**

(73) Patentinhaber: **SIEMENS AKTIENGESELLSCHAFT**
**80333 München (DE)**

(72) Erfinder: **BOSSELMANN, Thomas**
**D-91054 Erlangen (DE)**

(56) Entgegenhaltungen:
**EP-A- 0 390 581        EP-A- 0 410 234**
**EP-A- 0 586 226        GB-A- 2 135 050**

**Beschreibung**

Die Erfindung betrifft ein Verfahren und eine Vorrichtung zum Messen einer elektrischen Wechselspannung oder eines elektrischen Wechselfeldes. Unter einer Wechselspannung oder einem Wechselfeld wird dabei eine zeitlich veränderliche elektrische Spannung bzw. ein zeitlich veränderliches elektrisches Feld verstanden, deren jeweilige Frequenzspektra oberhalb einer vorbestimmten Grenzfrequenz liegen.

Es sind optische Meßverfahren und Meßvorrichtungen zum Messen elektrischer Spannungen und Felder bekannt, bei denen die Änderung der Polarisation von polarisiertem Meßlicht in Abhängigkeit von der elektrischen Spannung oder dem elektrischen Feld infolge des elektrooptischen Pockels-Effekts ausgewertet wird. Unter dem elektrooptischen Pockels-Effekt versteht man die Änderung der Polarisation von polarisiertem Meßlicht in einem den Pockels-Effekt aufweisenden Material infolge einer in dem Material induzierten linearen Doppelbrechung, die im wesentlichen über den elektrooptischen Koeffizienten linear abhängig von einem das Material durchdringenden elektrischen Feld ist. Zum Messen eines elektrischen Feldes wird ein Pockels-Element aus einem den Pockels-Effekt zeigenden Material in dem elektrischen Feld angeordnet. Zum Messen einer elektrischen Spannung wird die zu messende Spannung an zwei dem Pockels-Element zugeordnete Elektroden angelegt und das entsprechende, anliegende elektrische Feld gemessen. Durch das Pockels-Element wird polarisiertes Meßlicht gesendet, und die Änderung der Polarisation des polarisierten Meßlichts in Abhängigkeit von der zu messenden Spannung oder dem zu messenden Feld wird mit Hilfe eines Polarisationsanalysators ausgewertet.

Bei einer aus der DE-C-34 04 608 bekannten Meßvorrichtung zum Messen der elektrischen Feldstärke ist eine im zu messenden elektrischen Feld angeordnete Sensoreinrichtung ist über einen ersten Lichtleiter mit einer Lichtquelle und über zwei weitere Lichtleiter mit einer Meßeinrichtung optisch verbunden. Die Sensoreinrichtung besteht aus einer optischen Reihenschaltung einer ersten Linse, eines Polarisators, eines Viertelwellenlängenplättchens ($\lambda$/4-Plättchen), eines Pockels-Elements, eines polarisierenden Strahlteilers als Analysator und außerdem aus zwei dem Analysator zugeordneten weiteren Linsen. Das Licht der Lichtquelle wird über den ersten Lichtleiter und die erste Linse dem Polarisator zugeführt und vom Polarisator linear polarisiert. Das linear polarisierte Licht erfährt sodann in dem $\lambda$/4-Plättchen in einer Komponente eine Phasenverschiebung um $\pi$/2 und wird dadurch zirkular polarisiert. Dieses zirkular polarisierte Licht wird in das Pockels-Element eingekoppelt und durch das elektrische Feld im allgemeinen elliptisch polarisiert. Dieses elliptisch polarisierte Licht wird nun in dem Analysator in zwei linear polarisierte Lichtteilstrahlen A und B mit im allgemeinen senkrecht zueinander gerichteten Polarisationsebenen aufgespalten. Jedes dieser beiden Lichtteilsignale A und B wird über eine der beiden weiteren Linsen in einen der beiden weiteren Lichtleiter eingekoppelt, zu einem zugehörigen photoelektrischen Wandler in der Meßeinrichtung übertragen und dort jeweils in ein elektrisches Signal PA und PB umgewandelt. Aus den beiden elektrischen Signalen PA und PB wird anschließend von einem Rechner der Meßeinrichtung ein intensitätsnormiertes Meßsignal M = (PA-PB)/(PA+PB) abgeleitet. Dieses intensitätsnormierte Meßsignal M ist zum einen proportional zum Modulationsgrad als Maß für die elektrische Feldstärke und zum anderen weitgehend unabhängig von Intensitätsverlusten auf den Übertragungswegen oder Intensitätsschwankungen der Lichtquelle. Der Modulationsgrad ist dabei als Verhältnis von Signal-Ausgangswert zu Ruhe-Ausgangswert des Pockels-Elements definiert. Als Pockels-Element wird ein Kristall aus $Bi_4Ge_3O_{12}$ oder auch $Bi_4Si_3O_{12}$ mit Eulytin-Struktur verwendet, der keine optische Aktivität (intrinsische zirkulare Doppelbrechung) zeigt und eine nur relativ schwache Temperaturempfindlichkeit aufweist.

Ein Problem stellen Temperaturänderungen dar, die sich durch zusätzliche lineare Doppelbrechung in den optischen Materialien des Pockels-Elements und der optischen Übertragungsstrecken einschließlich des $\lambda$/4-Plättchens und damit verbundene Änderungen des Arbeitspunktes und der Meßempfindlichkeit bemerkbar machen können.

Aus der EP-A-0 586 226 ist eine Ausführungsform einer optischen Meßvorrichtung zum Messen einer elektrischen Wechselspannung bekannt, bei der Temperatureinflüsse kompensiert werden. Es ist eine optische Reihenschaltung aus einem Polarisator, einem $\lambda$/4-Plättchen, einem Pockels-Element und einem polarisierten Strahlteiler als Analysator optisch zwischen eine Lichtquelle und eine Auswerteeinheit geschaltet. Die Reihenfolge von $\lambda$/4-Plättchen und Pockels-Element in der optischen Reihenschaltung kann allerdings auch vertauscht sein. Das Meßlicht der Lichtquelle wird in dem Polarisator linear polarisiert und nach Durchlaufen des Pockels-Elements in dem Analysator in zwei Lichtteilsignale A und B mit unterschiedlichen Polarisationsebenen aufgespalten. Jedes dieser Lichtteilsignale A und B wird in ein entsprechendes elektrisches Intensitätssignal PA bzw. PB umgewandelt. Sodann wird zur Intensitätsnormierung für jedes dieser beiden elektrischen Intensitätssignale PA und PB der Quotient QA = PA(AC)/PA(DC) bzw. QB = PB(AC)/PB(DC) aus seinem zugehörigen Wechselsignalanteil PA(AC) bzw. PB(AC) und seinem zugehörigen Gleichsignalanteil PA(DC) bzw. PB(DC) gebildet. Aus den beiden intensitätsnormierten Quotienten QA und QB wird nun in einer Recheneinheit ein Meßsignal M = 1/(($\alpha$/QA)-($\beta$/QB)) gebildet mit den reellen Konstanten $\alpha$ und $\beta$. Durch Anpassung dieser Konstanten $\alpha$ und $\beta$ wird das Meßsignal M weitgehend unabhängig von durch Temperaturänderungen verursachter linearer Doppelbrechung im $\lambda$/

4-Plättchen.

Bei einem aus DE-A-39 24 369 bekannten Meßverfahren werden analog zu den bereits beschriebenen, aus DE-C-34 04 608 und EP-A-0 586 226 bekannten Ausführungsformen von einem Analysator das durch die Pockels-Sensoreinrichtung gelaufene Meßlicht in zwei Lichtteilsignale A und B mit orthogonalen Polarisationsebenen zerlegt. Zur Kompensation von Temperatureinflüssen wird eine Differenz der Gleichanteile der beiden Lichtteilsignale als Funktionswert für die Temperatur ermittelt. Mit dieser Differenz der Gleichanteile und einer Differenz der entsprechenden Wechselanteile der beiden Lichtteilsignale wird ein temperaturkompensiertes Meßsignal abgeleitet. Eine Kompensation von Lichtintensitätsschwankungen der Lichtquelle oder in den optischen Übertragungsstrecken ist mit diesem bekannten Verfahren nicht möglich.

In zwei weiteren nicht vorveröffentlichten Anmeldeschriften werden ebenfalls optische Meßverfahren mit Mitteln zur Temperaturkompensation vorgeschlagen. In der nach Art. 54 (3) und (4) EPÜ als Stand der Technik zu berücksichtigenden WO 94/24573 wird ein magnetooptisches Meßverfahren und eine magnetooptische Meßvorrichtung zum Messen eines Wechselstroms in einem Stromleiter vorgeschlagen, bei denen die Polarisationsebene von linear polarisiertem Licht in einem den Stromleiter umgebenden Faraday-Element um einen Meßwinkel gedreht wird. Der Meßwinkel ist ein Maß für die Stromstärke. Das Licht mit gedrehter Polarisation wird in zwei linear polarisierte Lichtsignale mit senkrecht zueinander gerichteten Polarisationsebenen aufgeteilt, die in optoelektrischen Wandlern in entsprechende elektrische Signale umgesetzt werden. Aus diesen elektrischen Signalen wird ein Funktionswert gebildet, der ein Maß für die Temperatur ist. Mit diesem Funktionswert und einem der beiden elektrischen Signale wird ein temperaturkompensiertes Meßsignal für den Wechselstrom berechnet.

In der nach Art. 54 (3) und (4) EPÜ als Stand der Technik zu berücksichtigenden WO 96/11409 werden ein Verfahren und eine Vorrichtung zum Messen einer elektrischen Wechselgröße vorgeschlagen, bei denen polarisiertes Licht in eine Sensoreinrichtung einkoppelt und nach Durchlaufen der Sensoreinrichtung in einem Analysator in zwei Lichtteilsignale mit unterschiedlicher linearer Polarisation zerlegt wird. Die entsprechenden elektrischen Intensitätssignale werden durch Division ihres jeweiligen Wechselsignalanteils durch ihren jeweiligen Gleichsignalanteil intensitätsnormiert. Aus den beiden intensitätsnormierten Signalen P1 und P2 wird ein temperaturkompensiertes Meßsignal M gemäß den Gleichungen S1 = F1(T)·M und S1 = F2(T)·M abgeleitet, wobei f1(T) und f2(T) vorgegebene, insbesondere lineare, quadratische oder exponentielle Fit-Funktionen der Temperatur T sind.

Der Erfindung liegt nun die Aufgabe zugrunde, ein Verfahren und eine Vorrichtung zum Messen einer elektrischen Wechselspannung oder eines elektrischen Wechselfeldes anzugeben, bei denen Einflüsse sowohl von Intensitätsänderungen als auch von Temperaturänderungen auf das Meßsignal weitgehend kompensiert werden.

Diese Aufgabe wird gemäß der Erfindung gelöst mit den Merkmalen des Anspruchs 1 bzw. des Anspruchs 8. In eine unter dem Einfluß der elektrischen Wechselspannung oder des elektrischen Wechselfeldes stehende Pockels-Sensoreinrichtung mit mindestens einem Pockels-Element wird polarisiertes Meßlicht eingekoppelt. Beim Durchlaufen des Pockels-Elements wird die Polarisation des Meßlichts in Abhängigkeit von der elektrischen Wechselspannung oder des elektrischen Wechselfeldes geändert. Nach wenigstens einmaligem Durchlaufen der Pockels-Sensoreinrichtung wird das Meßlicht von einem Analysator in ein erstes und ein zweites Lichtteilsignal aufgeteilt. Beide Lichtteilsignale sind linear polarisiert mit voneinander verschiedenen Polarisationsebenen. Anschließend werden die beiden Lichtteilsignale jeweils in ein entsprechendes erstes bzw. zweites elektrisches Intensitätssignal umgewandelt. Aus den beiden Intensitätssignalen werden von Normierungsmitteln gesondert intensitätsnormierte Signale abgeleitet, die praktisch unabhängig von Intensitätsschwankungen des Meßlichts aufgrund von Änderungen der Lichtstärke der Meßlichtquelle oder von Dämpfung in den optischen Übertragungsstrecken sind. Mit den beiden intensitätsnormierten Signalen wird ferner von ersten Auswertemitteln ein Funktionswert als eindeutiges Maß für die Temperatur gebildet. Mit diesem Funktionswert wird von zweiten Auswertemitteln die Temperaturabhängigkeit des intensitätsnormierten Signals weitgehend beseitigt und somit ein weitgehend temperaturkompensiertes und intensitätsschwankungskompensiertes Meßsignal für die Wechselspannung oder das Wechselfeld hergeleitet.

Die Erfindung geht aus von der Erkenntnis, daß die Gleichsignalanteile und die Wechselsignalanteile der beiden Lichtteilsignale sich in ihrer Temperaturabhängigkeit in charakteristischer Weise unterscheiden. Mit steigender Temperatur nimmt der Gleichsignalanteil des einen Lichtteilsignals zu, während der Gleichsignalanteil des anderen Lichtteilsignals abnimmt. Die Wechselsignalanteile beider Lichtteilsignale nehmen dagegen mit steigender Temperatur im allgemeinen beide zu oder beide ab. Die Erfindung beruht nun auf der Überlegung, daß aufgrund dieser unterschiedlichen, charakteristischen Temperaturabhängigkeiten von Gleichsignalanteilen und Wechselsignalanteilen der beiden Lichtteilsignale aus einem oder beiden zugehörigen elektrischen Intensitätssignalen ein Funktionswert als Maß für die Temperatur ermittelt werden kann und mit diesem Funktionswert die temperaturabhängige Arbeitspunktdrift und Änderung der Meßempfindlichkeit im intensitätsnormierten Signal korrigiert werden kann.

Vorteilhafte Ausführungsformen des Meßverfahrens und der Meßvorrichtung ergeben sich aus den jeweils abhängigen Ansprüchen.

Der Funktionswert für die Temperatur insbesondere in der Pockels-Sensoreinrichtung kann demnach in einer ersten Ausführungsform entweder aus Gleichsignalanteilen oder aus zeitlichen Mittelwerten der elektrischen Intensitätssignalen bestimmt werden. Dies kann mit Hilfe einer vorab ermittelten Wertetabelle oder einer vorab ermittelten Eichkurve erreicht werden, die experimentell bestimmt oder auch wenigstens teilweise theoretisch angenähert sein kann. Außerdem kann als Funktionswert auch einfach einer der beiden Gleichsignalanteile bzw. zeitlichen Mittelwerte allein oder eine Differenz oder ein Quotient der beiden Gleichsignalanteile bzw. zeitlichen Mittelwerte herangezogen werden.

In einer vorteilhaften Ausführungsform entspricht der Funktionswert einem Quotienten aus der Differenz und der Summe beider Gleichsignalanteile bzw. beider zeitlichen Mittelwerte oder einem Quotient aus einem der beiden Gleichsignalanteile bzw. zeitlichen Mittelwerte und der Summe beider Gleichsignalanteile bzw. zeitlichen Mittelwerte. In dieser Ausführungsform ist der Funktionswert selbst intensitätsnormiert.

Vorzugsweise entspricht jedes intensitätsnormierte Signal einem Quotienten aus einem Wechselsignalanteil und einem Gleichsignalanteil des zugehörigen Intensitätssignals. Damit können zusätzlich auch unterschiedliche Intensitätsänderungen in den optischen Übertragungswegen für die beiden Lichtteilsignale kompensiert werden. Diese Ausführungsform eignet sich daher insbesondere für Meßvorrichtungen, bei denen der Analysator mit jedem der beiden photoelektrischen Wandler zum Umwandeln der Lichtteilsignale in das zugehörige Intensitätssignal über einen Lichtleiter mit nicht vernachlässigbarer Dämpfung, insbesondere eine Multimode-Lichtfaser, optisch verbunden ist. Der Funktionswert kann nun als Differenz oder als Quotient der beiden intensitätsnormierten Signale bestimmt werden oder auch mit Hilfe einer vorab ermittelten Wertetabelle oder Eichkurve ermittelt werden. Da die beiden intensitätsnormierten Signale im wesentlichen unabhängig von Intensitätsschwankungen sind, ist auch der Funktionswert in dieser Ausführungsform intensitätsschwankungskompensiert.

Wenn der Funktionswert aus einem oder beiden Intensitätssignalen oder dem einen oder beiden intensitätsnormierten Signalen mittels einer Wertetabelle oder Eichfunktion abgeleitet wird, kann der Bestimmung des Funktionswertes eine vorgegebene, beispielsweise lineare oder quadratische, Interpolations- oder Fitfunktion zugrunde gelegt werden. Damit kann die Zahl der erforderlichen Eichmessungen zumindest reduziert werden.

Ein besonderer Vorteil gemäß der Erfindung besteht darin, daß entweder der Funktionswert selbst oder ein daraus ableitbarer Temperaturmeßwert als Information über die Systemtemperatur zur Verfügung steht und an einem dafür vorgesehenen Ausgang abgegriffen werden kann.

Das Meßsignal wird aus dem ersten oder zweiten Intensitätssignal oder dem intensitätsnormierten Signal und dem Funktionswert vorzugsweise mit Hilfe einer vorgegebenen Wertetabelle oder Eichkurve abgeleitet.

Zur weiteren Erläuterung der Erfindung wird auf die Zeichnung Bezug genommen, in deren einziger Figur ein Ausführungsbeispiel einer Vorrichtung zum Messen einer elektrischen Wechselspannung mit zwei intensitätsnormierten Signalen schematisch veranschaulicht ist.

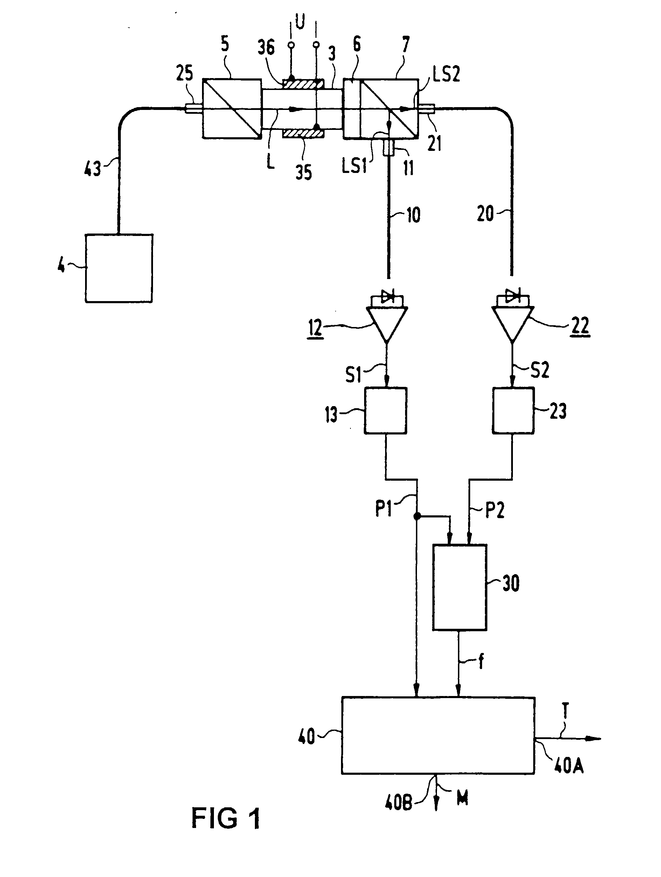

In der Ausführungsform gemäß der FIG 1 ist ein Pockels-Element 3 vorgesehen, das unter dem Einfluß der elektrischen Wechselspannung U die Polarisation von in das Pockels-Element 3 eingestrahltem polarisierten Meßlicht in Abhängigkeit von der elektrischen Wechselspannung U ändert. Die zu messende Wechselspannung U ist über zwei Elektroden 35 und 36 an das Pockels-Element 3 anlegbar. In den dargestellten Ausführungsformen wird die Wechselspannung U senkrecht zur Lichtausbreitungsrichtung des Meßlichts L angelegt (transversale Ausführungsform). Die Wechselspannung U kann aber auch parallel zur Lichtausbreitungsrichtung angelegt werden (longitudinale Ausführungsform). In das Pockels-Element 3 wird polarisiertes Meßlicht L eingekoppelt. Als Mittel zum Einkoppeln des Meßlichtes L in das Pockels-Element 3 sind eine Lichtquelle 4, beispielsweise eine Leuchtdiode, und ein Polarisator 5 zum linearen Polarisieren des Lichts der Lichtquelle 4 vorgesehen. Die Lichtquelle 4 und der Polarisator 5 sind vorzugsweise über einen Lichtleiter 43, beispielsweise eine Multimode-Lichtfaser, optisch miteinander verbunden, können aber auch durch eine Freistrahlkopplung optisch miteinander gekoppelt sein. Zum Koppeln des Lichts aus dem Lichtleiter 43 in den Polarisator 5 ist vorzugsweise eine Kollimatorlinse (GRIN, d.h. gradient index lens) 25 vorgesehen. Aus dem Polarisator 5 wird das nun linear polarisierte Meßlicht L in das Pockels-Element 3 eingekoppelt.

Das polarisierte Meßlicht L durchläuft das Pockels-Element 3 wenigstens einmal und erfährt dabei aufgrund des elektrooptischen Pockels-Effekts eine von der elektrischen Wechselspannung U abhängige Änderung seiner Polarisation. Nach Durchlaufen des Pockels-Elements 3 wird das Meßlicht L über ein λ/4-Plättchen 6 dem Analysator 7 zugeführt. Das λ/4-Plättchen 6 verschiebt zwei in ihren elektrischen Feldvektoren im allgemeinen senkrecht zueinander gerichtete Lichtanteile in ihrer Phase um ein Viertel der Wellenlänge λ gegeneinander. Das Pockels-Element 3 und das λ/4-Plättchen 6 bilden zusammen eine Pockels-Sensoreinrichtung. In dem Analysator 7 wird das Meßlicht L in ein erstes und ein zweites linear polarisiertes Lichtteilsignal LS1 bzw. LS2 zerlegt, deren Polarisationsebenen verschieden voneinander sind. Vorzugsweise sind die Polarisationsebenen der beiden Lichtteilsignale LS1 und LS2 senkrecht zueinander gerichtet (orthogonale Zerlegung). Als Analysator 7 können ein polarisierender Strahlteiler, beispielsweise ein Wollaston-Prisma, oder auch zwei um einen vorgegebenen Winkel, vorzugsweise 90°, gekreuzte Polarisationsfilter und ein vorgeschalteter einfacher Strahlteiler vorgesehen sein. Der Analysator 7 und das λ/4-Plättchen 6 können wie dargestellt räumlich unmittelbar nebeneinander angeordnet sein oder auch über eine Freistrahlanordnung in räumlicher Entfernung zueinander oder einen polarisationserhaltenden Lichtleiter optisch verbunden sein.

Der Arbeitspunkt der Meßvorrichtung wird vorzugsweise so eingestellt, daß am Analysator 7 zirkular polarisiertes Meßlicht anliegt, wenn am Pockels-Element 3 keine elektrische Spannung oder kein elektrisches Feld anliegt. Die beiden Eigenachsen der linearen Doppelbrechung im Pockels-Element 3 sind in diesem Fall vom Meßlicht L "gleichmäßig ausgeleuchtet". Das bedeutet, daß die auf die beiden Eigenachsen projizierten Komponenten des Meßlichts L jeweils die gleiche Intensität aufweisen. Im allgemeinen sind dann die beiden Lichtteilsignale LS1 und LS2 ebenfalls gleich stark in ihrer Intensität für U = 0 V. Bei Anlegen einer Wechselspannung U ≠ 0 V an das Pockels-Element 3 werden die Komponenten des Meßlichts L entlang der elektrooptisch aktiven Eigenachsen der linearen Doppelbrechung des Pockels-Elements 3 in ihrer Intensität in Abhängigkeit von der Wechselspannung U geändert.

Die beiden Lichtteilsignale LS1 und LS2 des Analysator 7 werden vorzugsweise über jeweils eine Kollimatorlinse 11 bzw. 21 in jeweils einen Lichtleiter 10 bzw. 20 eingekoppelt und über diesen Lichtleiter 10 bzw. 20 jeweils einem photoelektrischen Wandler 12 bzw. 22 zugeführt. Als Wandler 12 und 22 können beispielsweise in Verstärkerkreise geschaltete Photodioden vorgesehen sein. In den Wandlern 12 und 22 werden die beiden Lichtteilsignale LS1 und LS2 jeweils in ein erstes bzw. zweites elektrisches Intensitätssignal S1 bzw. S2 umgewandelt, das ein Maß für die Intensität des zugehörigen Lichtteilsignals LS1 bzw. LS2 ist.

Die Übertragung der beiden Lichtteilsignale LS1 und LS2 vom Analysator 7 zu dem jeweils zugehörigen Wandler 12 bzw. 22 kann auch über eine Freistrahlanordnung erfolgen.

Anstelle der in FIG 1 dargestellten optischen Reihenschaltung des Polarisators 5, des Pockels-Elements 3, des λ/4-Plättchens 6 und des Analysators 7 kann auch eine optische Reihenschaltung aus dem Polarisator 5, dem λ/4-Plättchen 6, dem Pockels-Element 3 und dem Analysator 7 vorgesehen sein, also die Reihenfolge des λ/4-Plättchens 6 und des Pockels-Elements 3 gerade vertauscht sein. In diesem Fall wird das Meßlicht L vor dem Einkoppeln in das Pockels-Element 3 zirkular polarisiert. Das Pockels-Element 3 und der Analysator 7 können in diesem Fall über eine Freistrahlanordnung, insbesondere in unmittelbarem räumlichem Kontakt, oder auch über einen polarisationserhaltenden Lichtleiter, vorzugsweise eine Monomode-Lichtfaser wie beispielsweise eine HiBi(High Birefringence)-Faser oder eine polarisationsneutrale LoBi(Low Birefringence)-Faser, optisch miteinander verbunden sein.

Außerdem können anstelle der Lichtquelle 4 und des Polarisators 5 auch eine Lichtquelle zum Senden linear polarisierten Lichts wie beispielsweise eine Laserdiode und gegebenenfalls zusätzliche, nicht dargestellte polarisierende Mittel vorgesehen sein zum Einkoppeln von polarisiertem Meßlicht L in das Pockels-Element 3 bzw. das λ/4-Plättchen 6. Der Lichtleiter 43 ist dann vorzugsweise ein polarisationserhaltender Lichtleiter.

In jedem Fall ist die das Pockels-Element 3 und das λ/4-Plättchen 6 umfassende Pockels-Sensoreinrichtung optisch zwischen die Mittel zum Einkoppeln von polarisiertem Meßlicht L und den Analysator 7 geschaltet.

In der in FIG 1 dargestellten Ausführungsform wird jedes elektrische Intensitätssignal S1 und S2 gesondert von zugeordneten Normierungsmitteln 13 bzw. 23 intensitätsnormiert. Die jeweiligen intensitätsnormierten Signale P1 bzw. P2 stehen an jeweils einem Ausgang der Normierungsmittel 13 bzw. 23 an.

Vorzugsweise wird jedes der beiden Intensitätssignale S1 und S2 in den zugeordneten Normierungsmitteln 13 bzw. 23 in seinen Gleichsignalanteil (DC-Signal) D1 bzw. D2 und seinen Wechselsignalanteil (AC-Signal) A1 bzw. A2 zerlegt, beispielsweise mit Hilfe von Tiefpaß- bzw. Hochpaßfiltern mit einer vorgebenen Trennfrequenz. Die Trennfrequenz ist so gewählt, daß der Wechselsignalanteil A1 bzw. A2 alle Informationen über die Wechselspannung oder das Wechselfeld, insbesondere also alle Frequenzanteile der Wechselspannung U bzw. des Wechselfeldes, enthält. Für jedes Intensitätssignal S1 und S2 wird dann das intensitätsnormierte Signal P1 bzw. P2 als Quotient

$$P1 = A1/D1 \ (\text{oder } P1 = D1/A1) \qquad (1)$$

bzw.

$$P2 = A2/D2 \ (\text{oder } P2 = D2/A2) \qquad (2)$$

aus seinem Wechselsignalanteil A1 bzw. A2 und seinem Gleichsignalanteil D1 bzw. D2 gebildet. Durch diese Intensitätsnormierung der Intensitätssignale S1 und S2 können Intensitätsschwankungen nicht nur der Lichtquelle 4 oder durch Dämpfung im Lichtleiter 43, sondern auch in den für die entsprechenden Lichtsignale LS1 und LS2 vorgesehenen Übertragungsstrecken sowie Empfindlichkeitsunterschiede in diesen beiden Übertragungsstrecken ausgeglichen werden. Dies ist insbesondere dann von Vorteil, wenn diese Übertragungsstrecken relativ lang sind, beispielsweise wenn der Analysator 7 in der Nähe der Pockels-Sensoreinrichtung angeordnet ist. Die Lichtsignale LS1 und LS2 können in dieser Ausführungsform insbesondere auch über Multimode-Lichtfasern als Übertragungsstrecken mit unterschiedlichen Dämpfungen übertragen werden, die den strahlteilenden Analysator 7 und die photoelektrischen Wandler 12 bzw. 22 miteinander verbinden.

Ein Problem bereiten nun Änderungen der Temperatur und die damit verbundene Verschiebung des Arbeitspunktes und Änderung der Meßempfindlichkeit der Meßvorrichtung, die sowohl in den unnormierten Intensitätssignalen S1 und S2 als auch in den intensitätsnormierten Signalen P1 und P2 und P zu beobachten sind. Insbesondere die temperaturinduzierte lineare Doppelbrechung in den optischen Materialien der optischen Meßvorrichtung, insbesondere des Pockels-Elements 3 oder auch des λ/4-Plättchens 6, führt zu Meßfehlern. Die temperaturinduzierten Meßfehler werden nun durch ein im folgenden beschriebenes Temperaturkompensationsverfahren weitgehend kompensiert.

In der in FIG 1 dargestellten Ausführungsform wird eines der beiden intensitätsnormierten Signale, beispielsweise P1, als noch nicht temperaturkompensiertes Meßsignal angesehen. Aus beiden intensitätsnormierten Signalen P1 und P2 wird nun von ersten Auswertemitteln 30 ein Funktionswert f(P1,P2) gebildet, der ein eindeutiges Maß für die Temperatur T ist. Dieser Funktionswert f kann gleich der Differenz

$$f = P1-P2 \text{ (oder P2-P1)} \qquad (3)$$

der beiden Signale P1 und P2 oder gleich dem Quotienten

$$f= P1/P2 \text{ (oder P2/P1)} \qquad (4)$$

der beiden Signale P1 und P2 sein. Sowohl die Differenz P1-P2 (P2-P1) als auch der Quotient P1/P2 (P2/P1) der beiden intensitätsnormierten Signale P1 und P2 enthalten eine eindeutige Information über die Temperatur T des optischen Systems.

Insbesondere für eine höhere Genauigkeit kann der Funktionswert f aber auch mittels einer vorab ermittelten Wertetabelle oder Eichfunktion bestimmt werden, die einem Wertepaar der beiden intensitätsnormierten Signale P1 und P2 den Funktionswert f(P1,P2) zuordnet. Der Funktionswert f kann auch durch Anpassung (Fitting) der Funktion f(P1,P2) an eine Vergleichsfunktion (Fitfunktion) ermittelt werden. Als Vergleichsfunktion für eine solche Interpolation eignen sich insbesondere lineare oder quadratische Funktionen von P1 und P2 oder auch ein Quotient (a·P1-b·P2)/(c·P1-d·P2) aus zwei linearen Funktionen von P1 und P2 mit anzupassenden reellen Koeffizienten a, b, c und d. Durch ein solches Fitting kann der Eichaufwand reduziert werden.

Die ersten Auswertemittel 30 enthalten entsprechende digitale oder analoge Komponenten zum Durchführen der genannten Operationen, beispielsweise einen Mikroprozessor oder einen digitalen Signalprozessor.

Das intensitätsnormierte Signal P1 und der Funktionswert f(PI,P2) werden jeweils einem Eingang von zweiten Auswertemitteln 40 zugeführt. Diese zweiten Auswertemittel 40 ermitteln aus dem Funktionswert f(P1,P2) einen Temperaturmeßwert T für die Temperatur, der vorzugsweise an einem Ausgang 40A der zweiten Auswertemittel 40 abgegriffen werden kann. Vorzugsweise ist in den zweiten Auswertemitteln 40 dazu eine vorab ermittelte Wertetabelle oder Eichkurve gespeichert, mit der beispielsweise von einem Mikroprozessor dem Funktionswert f der entsprechende Temperaturmeßwert T zugeordnet wird. Mit dem Temperaturmeßwert T wird aus dem intensitätsnormierten Signal P1 von den zweiten Auswertemitteln 40 ein in seinem Temperaturgang korrigiertes Meßsignal M für die Wechselspannung U ermittelt, das an einem weiteren Ausgang 40B der zweiten Auswertemittel 40 ansteht.

Zum Ableiten des Meßsignals M kann natürlich auch direkt der Funktionswert f(P1,P2) verwendet werden ohne vorherige Umwandlung in einen Temperaturmeßwert T.

Zum Ermitteln des Meßsignals M werden somit das intensitätsnormierte Signal P1 oder P2 einerseits und der Funktionswert f als Maß für die Temperatur oder der Temperaturmeßwert T andererseits herangezogen. Das Meßsignal M wird aus dem Signal P1 bzw. P2 durch Korrektur mit dem Funktionswert f selbst oder dem daraus ermittelten Temperaturmeßwert T vorzugsweise anhand einer Eichkurve oder Wertetabelle abgeleitet, die dem Wertepaar P1 bzw. P2 und f bzw. T das Meßsignal M zuordnet. Die Eichkurve oder die Wertetabelle kann wenigstens teilweise mit Hilfe einer Fitfunktion theoretisch angenähert oder experimentell durch Eichmessungen ermittelt sein.

Die Vorrichtung kann in einer nicht dargestellten Ausführungsform auch zum Messen eines elektrischen Wechselfeldes verwendet werden, indem man das Pockels-Element 3 in dem Wechselfeld anordnet.

Die vorbeschriebene Ausführungsform des Temperaturkompensationsverfahrens gemäß der Erfindung ist auch für an sich bekannte magnetooptische Meßverfahren und Meßvorrichtungen zum Messen eines elektrischen Wechselstromes unter Ausnutzung des Faraday-Effekts geeignet. Bei solchen Verfahren und Vorrichtungen wird linear polarisiertes Meßlicht durch eine einem Stromleiter zugeordnete Faraday-Sensoreinrichtung geschickt, und beim Durchlaufen der Faraday-Sensoreinrichtung wird die Polarisationsebene des Meßlichts in Abhängigkeit von einem Strom in dem Stromleiter durch das von diesem Strom erzeugte Magnetfeld gedreht. Diese Drehung der Polarisationsebene wird mit einem Polarisationsanalysator analysiert. Dazu wird das Meßlicht nach wenigstens einmaligem Durchlaufen der Faraday-Sensoreinrichtung aus der Faraday-Sensoreinrichtung ausgekoppelt und von einem Analysator, beispielsweise einem Wollaston-Prisma, in zwei linear polarisierte Lichtteilsignale zerlegt. Mit den erhaltenen Lichtteilsignale wird nun in gleicher Weise verfahren wie mit den beiden Lichtteilsignalen LS1 und LS2 bei den vorbeschriebenen Ausführungsbeispielen zur Spannungsmessung. Zunächst werden die beiden Lichtteilsignale also jeweils photoelektrisch in ein elektrisches Intensitätssignal umgewandelt, und dann wird aus wenigstens einem der zwei zugehörigen Intensitätssignale ein Funktionswert für die Temperatur T hergeleitet. Mit diesem Funktionswert und wenigstens einem der beiden Intensitätssignale wird ein weitgehend temperaturunabhängiges Meßsignal für den Wechselstrom ermittelt. Zum Ableiten des Funktionswertes für die Temperatur und des Meßsignals aus diesem Funktionswert und dem wenigstens einen Intensitätssignal können alle vorne für die Messung einer Wechselspannung oder eines Wechselfeldes beschriebenen Ausführungsformen verwendet werden.

**Patentansprüche**

1. Verfahren zum Messen einer elektrischen Wechselspannung (U) oder eines elektrischen Wechselfeldes unter Ausnutzung des Pockels-Effekts, bei dem

   a) polarisiertes Meßlicht (L) in eine unter dem Einfluß der elektrischen Wechselspannung (U) oder des elektrischen Wechselfeldes stehende Pockels-Sensoreinrichtung mit wenigstens einem Pockels-Element (3) eingekoppelt wird;
   b) die Polarisation des Meßlichts (L) beim Durchlaufen des wenigstens einen Pockels-Elements (3) in Abhängigkeit von der Wechselspannung (U) oder dem Wechselfeld geändert wird;
   c) das Meßlicht (L) nach wenigstens einmaligem Durchlaufen der Pockels-Sensoreinrichtung von einem Analysator (7) in zwei linear polarisierte Lichtteilsignale (LS1,LS2) mit unterschiedlichen Polarisationsebenen aufgeteilt wird;
   d) die beiden Lichtteilsignale (LS1,LS2) jeweils in ein erstes bzw. zweites elektrisches Intensitätssignal (S1, S2), das ein Maß für die Lichtintensität des zugehörigen Lichtteilsignals (LS1,LS2) ist, umgewandelt werden;
   e) die beiden elektrischen Intensitätssignale (S1, S2) gesondert zu intensitätsnormierten Signalen (P1, P2) intensitätsnormiert werden;
   f) aus den beiden erhaltenen intensitätsnormierten Signalen (P1,P2) in ersten Auswertemitteln (30) ein Funktionswert (f) abgeleitet wird, der ein eindeutiges Maß für die Temperatur ist;
   g) mit dem Funktionswert (f) und einem der intensitätsnormierten Signale (P1,P2) in zweiten Auswertemitteln (40) ein von Temperaturänderungen und Lichtintensitätsänderungen weitgehend unabhängiges Meßsignal (M) für die elektrische Wechselspannung (U) oder das elektrische Wechselfeld ermittelt wird.

2. Verfahren nach Anspruch 1, bei dem jedes intensitätsnormierte Signal (P1,P2) einem Quotienten aus einem Wechselsignalanteil und einem Gleichsignalanteil des zugehörigen Intensitätssignals (S1,S2) entspricht.

3. Verfahren nach Anspruch 1 oder Anspruch 2, bei dem der Funktionswert (f) einer Differenz (P1-P2) der beiden intensitätsnormierten Signale (P1,P2) entspricht.

4. Verfahren nach Anspruch 1 oder Anspruch 2, bei dem der Funktionswert (f) einem Quotienten (P1/P2) der beiden intensitätsnormierten Signale (P1,P2) entspricht.

5. Verfahren nach einem der Ansprüche 1 oder 2, bei dem der Funktionswert (f) mit Hilfe einer vorab ermittelten Wertetabelle oder Eichkurve abgeleitet wird.

6. Verfahren nach einem der Ansprüche 1 oder 2, bei dem der Funktionswert (f) mit Hilfe einer vorgegebenen Fit-Funktion abgeleitet wird.

7. Verfahren nach einem der vorhergehenden Ansprüche, bei dem das Meßsignal (M) mit Hilfe einer vorab ermittelten Wertetabelle oder Eichkurve bestimmt wird.

8. Vorrichtung zum Messen einer elektrischen Wechselspannung (U) oder eines elektrischen Wechselfeldes mit

   a) Mitteln (4,34) zum Einkoppeln von polarisiertem Meßlicht (L) in eine unter dem Einfluß der Wechselspannung (U) oder des Wechselfeldes stehende Pockels-Sensoreinrichtung mit wenigstens einem Pockels-Element (3), das die Polarisation des Meßlichts (L) in Abhängigkeit von der Wechselspannung (U) oder dem Wechselfeld ändert,
   b) einem Analysator (7) zum Aufteilen des Meßlichts (L) nach wenigstens einmaligem Durchlaufen der Pockels-Sensoreinrichtung in zwei linear polarisierte Lichtteilsignale (LS1,LS2) mit unterschiedlichen Polarisationsebenen,
   c) photoelektrischen Wandlern (12,22) zum Umwandeln der beiden Lichtteilsignale (LS1,LS2) in jeweils ein erstes bzw. zweites elektrisches Intensitätssignal (S1,S2), das ein Maß für die Intensität des zugehörigen Lichtteilsignals (LS1,LS2) ist,

d) Normierungsmitteln (13, 23) zur gesonderten Intensitätsnormierung der beiden Intensitätssignale (S1,S2) zu intensitätsnormierten Signalen (P1,P2),

e) ersten Auswertemitteln (30) zum Ableiten eines Funktionswertes (f), der ein eindeutiges Maß für die Temperatur ist, aus den beiden intensitätsnormierten Signalen (P1,P2),

f) zweiten Auswertemitteln (40) zum Ermitteln eines von Temperaturänderungen und Intensitätsänderungen weitgehend unabhängigen Meßsignals (M) für die elektrische Wechselspannung (U) oder das elektrische Wechselfeld aus einem der beiden intensitätsnormierten Signale (P1,P2) und dem Funktionswert (f).

9. Vorrichtung nach Anspruch 8, bei der

a) der Analysator (7) mit den photoelektrischen Wandlern (12,22) über jeweils einen Lichtleiter (10,20) zum Übertragen der beiden Lichtteilsignale (LS1,LS2) optisch verbunden ist und

b) die Normierungsmittel (13,23) für beide Intensitätssignale (S1,S2) jeweils ein intensitätsnormiertes Signal (P1,P2) bilden, das einem Quotienten aus einem Wechselsignalanteil und einem Gleichsignalanteil des zugehörigen Intensitätssignal (S1,S2) entspricht.

10. Vorrichtung nach einem der Ansprüche 8 oder 9, bei der die ersten Auswertemittel (30) einen Ausgang aufweisen, an dem der Funktionswert (f) als Maß für die Temperatur abgreifbar ist.

11. Vorrichtung nach einem der Ansprüche 8 bis 10, bei der die zweiten Auswertemittel (40) aus dem Funktionswert (f) einen Temperaturmeßwert (T) für die Temperatur ableiten, der an einem Ausgang (40A) der zweiten Auswertemittel (40) abgreifbar ist.

**Claims**

1. Method for measuring an electric alternating voltage (U) or an electric alternating field by using the Pockels effect, in which

a) polarized measuring light (L) is coupled into a Pockels sensor device which is under the influence of the electric alternating voltage (U) or of the electric alternating field and has at least one Pockels element (3);

b) the polarization of the measuring light (L), upon passing through the at least one Pockels element (3), is changed as a function of the alternating voltage (U) or of the alternating field;

c) the measuring light (L), after passing at least once through the Pockels sensor device, is split by an analyser (7) into two linearly polarized light partial signals (LS1, LS2) having different planes of polarization;

d) the two light partial signals (LS1, LS2) are in each case converted into a first and second electric intensity signal (S1, S2) which is a measure of the light intensity of the associated light partial signal (LS1, LS2);

e) the two electric intensity signals (S1, S2) are separately intensity-normalized to form intensity-normalized signals (P1, P2);

f) a function value (f), which is an unequivocal measure of the temperature, is derived in first evaluation means (30) from the two intensity-normalized signals (P1, P2) obtained;

g) in second evaluation means (40), using the function value (f) and one of the intensity-normalized signals (P1, P2), a measured signal (M), which is largely independent of temperature changes and light intensity changes, is determined for the electric alternating voltage (U) or the electric alternating field.

2. Method according to Claim 1, in which each intensity-normalized signal (P1, P2) corresponds to a quotient of an AC signal component and a DC signal component of the associated intensity signal (S1, S2).

3. Method according to Claim 1 or Claim 2, in which the function value (f) corresponds to a difference (P1-P2) between the two intensity-normalized signals (P1, P2).

4. Method according to Claim 1 or Claim 2, in which the function value (f) corresponds to a quotient (P1/P2) of the two intensity-normalized signals (P1, P2).

5. Method according to either of Claims 1 or 2, in which the function value (f) is derived with the aid of a previously determined value table or calibration curve.

6. Method according to either of Claims 1 or 2, in which the function value (f) is derived with the aid of a predetermined fit function.

7. Method according to one of the preceding claims, in which the measured signal (M) is determined with the aid of a previously determined value table or calibration curve.

8. Device for measuring an electric alternating voltage (U) or an electric alternating field, having

a) means (4, 34) for coupling polarized measuring light (L) into a Pockels sensor device, which is under the influence of the alternating voltage (U) or of the alternating field and has at least one Pockels element (3) which changes the polarization of the measuring light (L) as a function of the alternating voltage (U) or of the alternating field,

b) an analyser (7) for splitting the measuring light (L), after passing at least once through the Pockels sensor device, into two linearly polarized light partial signals (LS1, LS2) having different planes of polarization,

c) photoelectric converters (12, 22) for converting the two light partial signals (LS1, LS2) in each case into a first and second electric intensity signal (S1, S2), which is a measure of the intensity of the associated light partial signal (LS1, LS2),

d) normalization means (13, 23) for the separate intensity normalization of the two intensity signals (S1, S2) to form intensity-normalized signals (P1, P2),

e) first evaluation means (30) for deriving a function value (f), which is an unequivocal measure of the temperature, from the two intensity-normalized signals (P1, P2),

f) second evaluation means (40) for determining a measured signal (M), which is largely independent of temperature changes and intensity changes, for the electric alternating voltage (U) or the electric alternating field from one of the two intensity-normalized signals (P1, P2) and the function value (f).

9. Device according to Claim 8, in which

a) the analyser (7) is optically connected to the photoelectric converters (12, 22) via in each case an optical waveguide (10, 20) for transmitting the two light partial signals (LS1, LS2), and

b) the normalization means (13, 23) for both the intensity signals (S1, S2) in each case form an intensity-normalized signal (P1, P2) which corresponds to a quotient of an AC signal component and a DC signal component of the associated intensity signal (S1, S2).

10. Device according to either of Claims 8 or 9, in which the first evaluation means (30) have an output at which the function value (f) can be picked off as a measure of the temperature.

11. Device according to one of Claims 8 to 10, in which the second evaluation means (40) derive, from the function value (f), a temperature measured value (T) for the temperature, which can be picked off at an output (40A) of the second evaluation means (40).

**Revendications**

1. Procédé pour mesurer une tension (U) alternative électrique ou un champ alternatif électrique en utilisant l'effet Pockles, dans lequel

a) on injecte de la lumière (L) de mesure polarisée dans un dispositif détecteur Pockles comportant au moins un élément (3) Pockles et soumis à l'influence de la tension (U) alternative électrique ou du champ alternatif électrique ;

b) on fait varier la polarisation de la lumière (L) de mesure lors du passage dans le au moins un élément (3) Pockles en fonction de la tension (U) alternative ou du champ alternatif ;

c) on subdivise la lumière (L) de mesure, après au moins un premier passage dans le dispositif détecteur Pockles, par un analyseur (7), en deux signaux (LS1, LS2) partiels lumineux polarisés linéairement et ayant des plans de polarisation différents ;

d) on convertit les deux signaux (LS1, LS2) partiels lumineux respectivement en un premier signal (S1) d'intensité électrique et en un deuxième signal (S2) d'intensité électrique, qui sont une mesure de l'intensité lumineuse du signal (LS1, LS2) partiel lumineux associé ;

e) on norme en intensité les deux signaux (S1, S2) d'intensité électrique de manière séparée pour obtenir des signaux (P1, P2) normés en intensité ;

f) on tire des deux signaux (P1, P2) normés en intensité obtenus, dans des premiers moyens (30) d'exploitation, une valeur (f) de fonction qui est une valeur univoque de la température ;

g) en ayant la valeur (f) de fonction et l'un des signaux (P1, P2) normé en intensité, on détermine, dans des deuxièmes moyens (40) d'exploitation, un signal (M) de mesure, de la tension (U) alternative électrique ou du champ alternatif électrique dans une grande mesure indépendant de variations de température et de variations d'intensité lumineuse.

2. Procédé suivant la revendication 1, dans lequel chaque signal (P1, P2) normé en intensité correspond à un quotient d'une composante de signal alternatif et d'une composante de signal continu du signal (S1, S2) d'intensité associé.

3. Procédé suivant la revendication 1 ou la revendication 2, dans lequel la valeur (f) de fonction correspond à une différence (P1-P2) des deux signaux (P1, P2) normés en intensité.

4. Procédé suivant la revendication 1 ou la revendication 2, dans lequel la valeur (f) de fonction correspond à un quotient (P1/P2) des deux signaux (P1, P2) normés en intensité.

5. Procédé suivant l'une des revendications 1 ou 2, dans lequel la valeur (f) de fonction est déduite à l'aide d'une table de valeurs ou d'une courbe d'étalonnage déterminée à l'avance.

6. Procédé suivant l'une des revendications 1 ou 2, dans lequel la valeur (f) de fonction est déduite à l'aide d'une fonction Fit prescrite.

7. Procédé suivant l'une des revendications précédentes, dans lequel le signal (M) de mesure est déterminé à l'aide d'une table de valeurs ou d'une courbe d'étalonnage déterminée à l'avance.

8. Dispositif pour mesurer une tension (U) alternative électrique ou un champ alternatif électrique, comportant

a) des moyens (4, 34) pour injecter de la lumière (L) de mesure polarisée dans un dispositif détecteur Pockles soumis à l'influence de la tension (U) alternative ou du champ alternatif, comportant un élément (3) Pockles qui fait varier la polarisation de la lumière (L) de mesure en fonction de la tension (U) alternative ou du champ alternatif,

b) un analyseur (7) pour subdiviser la lumière (L) de mesure après au moins un premier passage dans le dispositif détecteur Pockles en deux signaux (LS1, LS2) partiels lumineux polarisés linéairement et ayant des plans de polarisation différents,

c) des convertisseurs (12, 22) photoélectriques pour convertir les deux signaux (LS1, LS2) partiels lumineux respectivement en un premier signal (S1) d'intensité électrique et en un deuxième signal (S2) d'intensité électrique, qui sont une mesure de l'intensité du signal partiel lumineux associé,

d) des moyens (13, 23) pour normer en intensité de manière séparée les deux signaux (S1, S2) d'intensité en vue d'obtenir des signaux (P1, P2) normés en intensité,

e) des moyens (30) d'exploitation pour déduire une valeur (f) de fonction, qui est une mesure univoque de la température, des deux signaux (P1, P2) normés en intensité,

f) des deuxièmes moyens (40) d'exploitation pour déterminer à partir des deux signaux (P1, P2) normés en intensité et de la valeur (f) de fonction un signal (M) de mesure de la tension (U) alternative électrique ou du champ alternatif électrique, qui est, dans une grande mesure, indépendant de variations de température et de variations d'intensité.

9. Dispositif suivant la revendication 8, dans lequel

a) l'analyseur (7) est relié du point de vue optique aux convertisseurs (12, 22) photoélectriques par l'intermédiaire chaque fois d'un guide (10, 20) de lumière servant à transmettre les deux signaux (LS1, LS2) partiels lumineux et

b) les moyens (13, 23) pour normer forment pour les deux signaux (S1, S2) d'intensité chaque fois un signal (P1, P2) normé en intensité qui correspond à un quotient d'une composante de signal alternative et d'une composante de signal continue du signal (S1, S2) d'intensité associé.

10. Dispositif suivant l'une des revendications 8 ou 9, dans lequel les premiers moyens (30) d'exploitation comportent une sortie à laquelle la valeur (f) de fonction peut être prélevée comme mesure de la température.

11. Dispositif suivant l'une des revendications 8 à 10, dans lequel les deuxièmes moyens (40) d'exploitation tirent de la valeur (f) de fonction une valeur (T) de mesure de la température, qui peut être prélevée à une sortie (40A) des deuxièmes moyens (40) d'exploitation.

FIG 1